# EUROPÄISCHE PATENTSCHRIFT

(11) **EP 2 792 619 B1**
(45) Veröffentlichungstag und Bekanntmachung des Hinweises auf die Patenterteilung: **09.12.2015**
(21) Anmeldenummer: 14001135.4
(22) Anmeldetag: 27.03.2014
(51) Int. Cl.: B65G 1/04

(54) **Verfahren zum Betreiben einer Einrichtung zum Lagern und Bereitstellen von in Gurtspulen aufgenommenen elektrischen Bauelementen**
Method for operating a device for storing and providing electrical components held in belt coils
Procédé de fonctionnement d'un dispositif de stockage et de mise à disposition d'éléments de construction électriques logés dans des bobines de ceinture

(30) Priorität: 16.04.2013 DE 102013006523
(43) Veröffentlichungstag der Anmeldung: 22.10.2014
(73) Patentinhaber: MIMOT GmbH, 79539 Lörrach (DE)
(72) Erfinder: Pfeil, Stephan, 79585 Steinen (DE)
(74) Vertreter: Müller Hoffmann & Partner

(56) Entgegenhaltungen:
- EP-A1- 1 666 382
- DE-U1-202004 006 920
- US-A1- 2002 018 705

## Beschreibung

Die Erfindung bezieht sich auf ein Verfahren zum Betreiben einer Einrichtung zum Lagern und Bereitstellen von in Gurtspulen aufgenommenen elektrischen Bauelementen für elektronische Geräte, wobei die Gurtspulen mit Identifikationsmitteln versehenen sind, die mittels einer Sensoreinrichtung erfasst werden, wobei die Gurtspulen mittels eines Handhabungsroboters in Ablagefächer einer Regaleinrichtung transportiert werden und wobei die Identitätsdaten der Gurtspulen und die zugeordneten Lagedaten des Ablagefachs in einen Datenspeicher geschrieben werden.

Ein derartige Einrichtung ist z.B. durch die DE202004006920 U1 bekannt geworden. Danach sind die Transportmittel als Handhabungsroboter ausgebildet, der einen in der Höhe positionierbaren Greifer aufweist, welcher um eine zentrale senkrechte Achse drehbar und radial verschiebbar gelagert ist. Die Ablagefächer sind um die Greiferachse zirkulär verteilt angeordnet und zu dieser hin offen. Die scheibenförmigen Gurtspulen sind mit einem Spulenkörper mit einer zentralen Nabe versehen und werden in eine Eingabeöffnung der Einrichtung einzeln flach liegend eingelegt. Die Eingabeöffnung weist einen optischen Sensor auf, mit dem eine optisch codierte Artikelnummer der einliegenden Gurtspule erfasst werden kann. Diese wird zwischen zwei parallelen flachen Greifelementen des Greifers eingeklemmt und fixiert. Der Greifer wird sodann in Winkel und Höhe auf die Zielkoordinaten des Ablagefachs eingestellt und radial zum Ablagefach verschoben.

Bei einer derartigen Lagereinrichtung ist es üblich, die Ein-und Ausgabevorgänge die Artikelnummern datentechnisch zu protokollieren und die Bestände fortzuschreiben, so dass bei Bedarf der gesamte Lagerinhalt abgerufen werden kann.

Der Erfindung liegt die Aufgabe zugrunde, die Sicherheit bei der Bestandfortschreibung zu erhöhen und die Belegungsgrad der Einrichtung zu erhöhen.

Diese Aufgabe wird durch die Erfindung gemäß Anspruch 1 gelöst.

Bei der einfachen Fortschreibung der Positionsdaten kann es langfristig z.B. durch technische Fehlfunktionen zu Abweichungen zwischen dem tatsächlichen Lagerbestand und den gespeicherten Daten kommen. Falls eine der Gurtspulen nicht auffindbar oder nicht vorhanden ist, wird dies bisher erst bei deren versuchter Entnahme bemerkt. Eine Ersatzspule muss dann aus einem vorgeschalteten Lager in einem gesonderten Abholzyklus herbeigeschafft werden, was einem erheblichen Mehraufwand und eine erheblichen Zeitverzögerung bewirken kann. Nach der Erfindung können nun die benötigten Gurtspulen frühzeitig vor deren Entnahme überprüft und fehlende Gurtspulen rechtzeitig ersetzt werden. Dabei wird die jeweilige Gurtspule in der Regel in das ursprüngliche Ablagefach zurück gelegt. Es ist aber auch möglich, die Gurtspule in ein anderes freies Ablagefach zu legen und dessen Daten abzuspeichern.

Eine Regaleinrichtung weist üblicherweise für unterschiedlich große Gurtspulen unterschiedlich große Ablagefächer auf. Dabei kann es vorkommen, dass bei voll belegten kleinen Fächern, kleine Gurtspulen in zu große Fächer eingelegt werden. Nach dem Freiwerden von kleinen Ablagefächern, ist es möglich die Gurtspulen entsprechend umzusortieren.

Eine Weiterbildung der Erfindung gemäß Anspruch 2 ermöglicht eine vollständige Überprüfung und Inventur der gespeicherten Gurtspulen. Ein solcher Lauf kann günstig in eine Zeitverlegt werden, in denen die Einrichtung nicht bestimmungsgemäß benutzt wird.

Durch eine andere Weiterbildung der Erfindung nach Anspruch 3 sind die auf dem Schieber aufliegenden Gurtspulen von oben im vollen Umfang frei einsehbar und können, ohne den Schieber zu verlassen, in den Erfassungsbereich der Sensoreinrichtung gehalten werden und müssen nicht auf eine stationäre Ablagefläche aufgelegt werden. Dadurch verringert sich der Zeitaufwand für die Überprüfung der Gurtspulen entsprechend.

Im Folgenden wird die Erfindung anhand eines in der Zeichnung dargestellten Ausführungsbeispieles näher erläutert. Es zeigt:

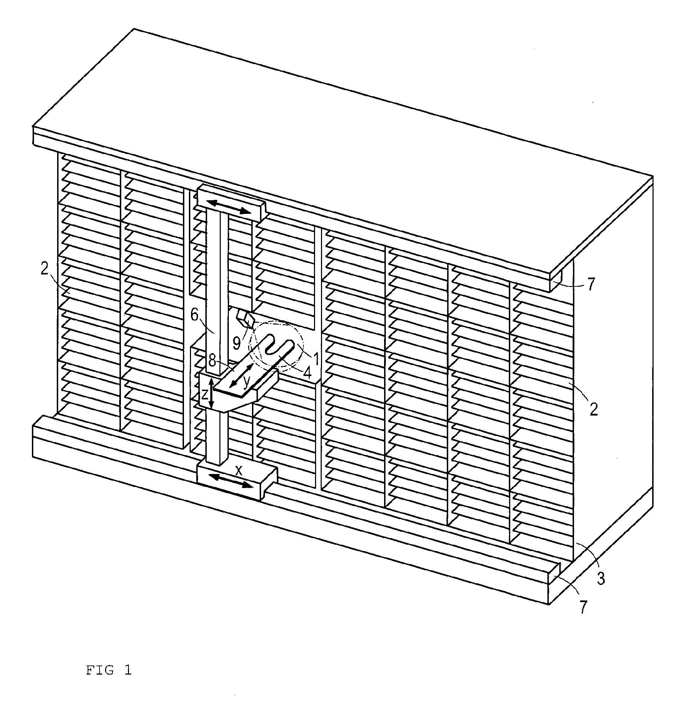

Figur 1 eine perspektivische Ansicht einer Einrichtung zum Lagern von Gurtspulen

Die dargestellt Figur zeigt schematisiert eine perspektivische Rückansicht einer Einrichtung zum Lagern und Bereitstellen von in Gurtspulen 1 aufgenommenen elektrischen Bauelementen. Die Gurtspulen 1 können in eine nicht dargestellte frontseitige Eingabestation eingesetzt und vorn dort mittels einer nicht dargestellten Übergabevorrichtung in eine Übergabeposition 3 transportiert werden, von wo aus sie mittels eines rückseitig angeordneten Handhabungsroboters in zur Rückseite hin offenen Ablagefächern 2 einer flächenhaften senkrecht stehenden Regaleinrichtung 3 abgelegt werden können. Beim Transport zu den Ablagefächern gelangen die Gurtspulen in den Erfassungsbereich einer an der Übergabeposition angeordneten optischen Sensoreinrichtung 9, die die auf der Gurtspule angebrachte Identitätsmarken erfassen kann. Die erfassten Identitätsdaten der Gurtspulen werden zusammen mit den Daten der zugehörigen Ablagefächer in einem gemeinsamen Datenspeicher abgelegt.

Der Handhabungsroboter ist als orthogonale Positioniereinrichtung ausgebildet, die einen senkrechten schlanken Träger 6 aufweist, der in einer stationären Längsführung 7 der Einrichtung in einer waagerechten Längsrichtung x verfahrbar ist. Am Träger 6 ist in einer senkrechten Richtung z ein Wagen 8 verschiebbar, an dem ein plattenartiger flacher Schieber 4 in einer Einschubrichtung y verschiebbar geführt ist, die zur Verschiebeebene des Wagens 8 senkrecht orientiert ist. Die in der Übergabeposition 3 befindliche Gurtspule 1 kann vom Schieber 4 erfasst, zur freien Rückseite verschoben, auf eines der freien Ablagefächer 2 eingestellt und in dieses eingeschoben werden. Der Schieber 4 ist so ausgebildet, dass die Oberseite der aufliegende Gurtspule frei bleibt.

Die Sensoreinrichtung ist in einem mittleren Bereich der Regaleinrichtung angeordnet. Die Gurtspulen können den Ablagefächern mit dem Schieber 4 entnommen und in den Erfassungsbereich der Sensoreinrichtung 9 transportiert werden. Die jeweils flach auf dem Schieber aufliegende Gurtspule 1 kann mit ihrer Oberseite von der Sensoreinrichtung voll eingesehen werden, so dass die unregelmäßig angeordneten Identitätsmarkierungen sicher erfasst und überprüft werden können. Im Falle einer Abweichung von den gespeicherten Daten werden diese mit den korrigierten Identitäts- und Ortsdaten der Ablagefächer überschrieben.

### Bezugszeichen

- x: Längsrichtung
- y: Einschubrichtung
- z: senkrechte Richtung
- 1: Gurtspule
- 2: Ablagefach
- 3: Regaleinrichtung
- 4: Schieber
- 5: Station
- 6: Träger
- 7: Längsführung
- 8: Wagen
- 9: Sensoreinrichtung

## Patentansprüche

1. Verfahren zum Betreiben einer Einrichtung zum Lagern und Bereitstellen von in Gurtspulen (1) aufgenommenen elektrischen Bauelementen für elektronische Geräte,
wobei die Gurtspulen mit Identifikationsmitteln versehen sind, die mittels einer Sensoreinrichtung erfasst werden,
wobei die Gurtspulen mittels eines Handhabungsroboters in Ablagefächer (2) einer Regaleinrichtung transportiert werden und
wobei die Identitätsdaten der Gurtspulen und die zugeordneten Lagedaten des Ablagefachs in einen Datenspeicher geschrieben werden,
**dadurch gekennzeichnet,**
**dass** jeweils eine der Gurtspulen in einem Kontrollmodus aus durch den Handhabungsroboter den ihrem Ablagefach entnommen und in den Erfassungsbereich der Sensoreinrichtung transportiert wird, die die Identität der Gurtspule erfasst,
**dass** die Gurtspule von dort durch den Handhabungsroboter in eines der Ablagefächer zurücktransportiert wird und
**dass** die Identitäts- und Positionsdaten der Gurtspule im Datenspeicher erneuert werden.

2. Verfahren nach Anspruch 1, **dadurch gekennzeichnet,**
**dass** in einem Durchlauf sukzessive alle in den Ablagefächern gelagerten Gurtspulen überprüft werden.

3. Verfahren nach Anspruch 1 oder 2, **dadurch gekennzeichnet,**
**dass** die Gurtspule mit ihrer flachen Unterseite auf einen plattenartig flachen Greifer aufgelegt wird, der die Oberseite der Gurtspule nicht bedeckt.

## Claims

1. Method for operating a device for storing and providing electrical components for electronic equipment accommodated in belt spools (1), wherein the belt spools are provided with identification means, which are recorded by means of a sensor device,
wherein the belt spools are transported by means of a handling robot in storage compartments (2) of a shelving facility and
wherein the identity data of the belt spools and the associated location data of the storage compartment are written into a data memory,
**characterised in that**,
each one of the belt spools is removed in a control mode from its storage compartment by the handling robot and is transported into the recording zone of the sensor device, which records the identity of the belt spool,
the belt spool is transported back from there by the handling robot into one of the storage compartments and
the identity and position data of the belt spool is renewed in the data memory.

2. Method in accordance with claim 1, **characterised in that**
all belt spools stored in the storage compartments are checked successively in one pass.

3. Method in accordance with claim 1 or 2, **characterised in that**
the belt spool with its flat underside is laid on a plate-like flat gripper that does not cover the upper side of the belt spool.

## Revendications

1. Procédé pour faire fonctionner un dispositif de stockage et d'approvisionnement en composants électriques, logés dans des bobines à bande (1), pour appareils électroniques,
étant précisé que les bobines à bande sont pourvues de moyens d'identification qui sont détectés à l'aide d'un dispositif à capteur,
que les bobines à bande sont transportées à l'aide d'un robot de manutention dans des casiers (2) d'un rayonnage et
que les données d'identité des bobines à bande et les données de position associées du casier sont inscrites dans une mémoire de données,
**caractérisé en ce que** l'une des bobines à bande est sortie de son casier par le robot de manutention, dans un mode de contrôle, et transportée jusque dans la zone de détection du dispositif à capteur, lequel détecte l'identité de la bobine à bande,
**en ce que** la bobine à bande, de là, est ramenée par le robot de manutention dans l'un des casiers, et
**en ce que** les données d'identité et de position de la bobine à bande sont renouvelées dans la mémoire de données.

2. Procédé selon la revendication 1, **caractérisé en ce que** dans un cycle, toutes les bobines à bande stockées dans les casiers sont successivement contrôlées.

3. Procédé selon la revendication 1 ou 2, **caractérisé en ce que** la bobine à bande est posée avec son côté inférieur plat sur un organe de préhension plat en forme de plaque qui ne couvre pas le côté supérieur de la bobine à bande.
